# EUROPEAN PATENT APPLICATION

(11) **EP 2 495 871 A1**
(43) Date of publication of application: **05.09.2012**
(21) Application number: 11290110.3
(22) Date of filing: 03.03.2011
(51) Int. Cl.: H03F 1/02

(54) **Doherty amplifier comprising different transistor technologies**

(71) Applicant: Alcatel Lucent, 75007 Paris (FR)
(72) Inventor: Thomas Merk, 70736 Fellbach (DE); Stefan Fuchs, 71732 Tamm (DE)
(74) Representative: 2SPL Patentanwälte

(57) **Abstract**

The invention relates to a Doherty amplifier comprising a main amplifier (110) and a peak amplifier (115) having their respective inputs connected to an input hybrid coupler (125). The outputs of the main amplifier (110) and the peak amplifier (115) are interconnected via an impedance transforming network (130). While the main amplifier (110) comprises an amplifying transistor of a first transistor technology (e.g. GaN), the peak amplifier (115) comprises a transistor of a second transistor technology (e.g. LDMOS) being different from the first transistor technology.

## Description

The present invention relates to amplification of electronic signals, more particularly but not exclusively to amplification of radio signals in base station transceivers of mobile communication systems.

### Background

Wireless networks are steadily growing and more and more systems for mobile communication are deployed. For example, multiple generations of cellular systems have been developed and introduced to the mass markets. With the continuous extension and improvement of these communication systems their inherent power consumption becomes more and more an issue. One of the major contributors to the power consumption of wireless communication systems are the base station transceivers, which are deployed to provide an almost 100% service coverage. The power consumption of a base station transceiver depends on several factors, where one major factor is the power consumption of the power amplifiers used for transmission of the RF signals (RF as abbreviation for radio frequency). Power Amplifiers are the most power consuming parts within a radio base station transceiver.

Therefore the efficiency of the power amplifier is critical to the overall power consumption of a base station transceiver and further to the power consumption of an entire network. Efficiency is a measure of how much of the source or supply power is usefully applied to the amplifier's output, i.e. radiated as RF power. In RF Power Amplifiers, such as cellular base stations and broadcast transmitters, special design techniques are used to improve efficiency. Doherty designs, which use a second transistor, can improve efficiency from the typical 15% up to 30-35% in a narrow bandwidth. Envelope tracking designs are able to achieve efficiencies of up to 60%, by modulating the supply voltage to the amplifier in line with the envelope of the signal.

Nowadays, in power amplifiers of base station transceivers LDMOS (as abbreviation for laterally diffused metal oxide semiconductor) transistors are used. These transistors can be fabricated via an epitaxial silicon layer on a highly doped silicon substrate. Such silicon-based FETs (as abbreviation for field effect transistor) are widely used in power amplifiers for base station transceivers, which may require high output power with a corresponding drain to source breakdown voltage usually above 60 volts, but a have lower maximum power gain frequency compared to other devices such as GaAs FETs.

Single LDMOS devices suffer from relatively poor efficiency when used in 3G or 4G (as abbreviation for 3^{rd} and 4^{th} generation) LTE-networks (as abbreviation for long term evolution), due to the higher peak-to-average power of the waveforms used. Former mobile communication systems made use of frequency division multiple access (FDMA for abbreviation) or time division multiple access (TDMA as abbreviation) schemes, where different user signals can be distinguished by their time and/or frequency characteristics in the transmission band. 3G and 4G systems using code division multiple access (CDMA for abbreviation) or orthogonal frequency division multiple access (OFDMA for abbreviation) make use of a superposition of the user signals in the transmission band and therewith transmission signals have a statistical dependence on the user signals resulting in higher dynamics, i.e. higher PAPRs (as abbreviation for peak-to-average-ratios). The characteristic of the power amplifiers is adapted to the signal characteristics, i.e. in 3G and 4G systems different power amplifiers adapted to the higher PAPRs are utilized.

The efficiency of LDMOS power amplifiers can be boosted using Doherty or Envelope Tracking techniques. The Doherty amplifier was invented by William H. Doherty in 1936, cf. Doherty, M (1936), "A new high efficiency power amplifier for modulated waves", Annual convention of the Institute of Radio Engineers. The amplifier is usually configured as a grounded-cathode, carrier-peak amplifier. Using two power transistors in modem implementations, one as a carrier transistor and the other as a peak transistor, the amplifier operates by cutting off the negative swing of the RF wave and adding it to the positive swing, greatly improving efficiency and wasting less energy than earlier RF amplifiers. Even though the efficiency of the power amplifiers has been improved over the years, they are still one major contributor for the power consumption and therewith to the operator costs of today's mobile communication networks.

### Summary

Embodiments can be based on the finding that an increased efficiency of power amplifiers can be achieved when using transistors of different transistor technologies. Furthermore, power amplifiers with higher efficiency than currently available power amplifiers can be developed by using different amplifier concepts, e.g. Doherty amplifier, asymmetric Doherty amplifier and/or using different transistor technologies. Embodiments may be further based on the finding that the currently widely used transistor technology for base station power amplifiers is LDMOS, a well proven technology in the 7th to 8th generation, which is coming closer and closer the its maximum efficiency. Embodiments can be further based on the finding that another relatively new technology is GaN, which is currently in the 1st to 2nd generation and already shows significantly better efficiency values. Embodiments can be further based on the finding that GaN and LDMOS technologies can be combined.

In embodiments a concept of an asymmetric Doherty amplifier with a power split ratio of 1:2 between the main and peak amplifier to improve efficiency at output back off of -7.8dB can be used. In embodiments this efficiency maximum can be mainly determined by the efficiency of the main transistor. Therefore, embodiments may utilize a highly efficient GaN-transistor as main device and a relatively cheap LDMOS-transistor as peak device. Embodiments may be further based on the finding of a hybrid amplifier structure, the term "Hybrid" in this case may refer to the two different transistor technologies used.

Embodiments provide a circuit adapted for amplifying an electrical signal. The circuit comprises a first amplifier branch comprising a first transistor adapted for amplifying the electrical signal, and a second amplifier branch comprising a second transistor adapted for amplifying the electrical signal, when the level of the electrical signal is above a predefined threshold. The first and the second transistors are based on different transistor technologies.

The first and the second amplifier branches can be coupled in parallel. The electrical signal can have a carrier part having a carrier amplitude and a modulation part having a peak amplitude, and the predefined threshold may separate the carrier amplitude from the peak amplitude.

In embodiments the first amplifier branch can be adapted for amplifying the carrier part and the modulation part of the electrical signal, and the second amplifier branch can be adapted for amplifying the peak amplitude. In other words, the second amplifier branch can be adapted for amplifying the electrical signal only if the level of the electrical signal exceeds a certain threshold, and for not amplifying otherwise, e.g. for switching its output to a high impedance otherwise. The level of the electrical signal may correspond to its instantaneous amplitude. In further embodiments, the second amplifier branch can be adapted for amplifying the electrical signal when a level of the electrical signal is above the predefined threshold, and for not amplifying the electrical signal when the level of the electrical signal is below the predefined threshold.

The first and the second transistors can be from the group of GaN, GaAs, GaC₂, Ge, Si, SiGe, LDMOS, MOSFET (abbreviating metal oxide semiconductor field effect transistor), IGBT (abbreviating insulated gate bipolar transistor), BJT (abbreviating bipolar junction transistor), JFET (abbreviating junction gate field-effect transistor), IGFET (abbreviating insulated gate FET). For example, the first transistor can correspond to a GaN-transistor and the second transistor can correspond to a LDMOS-transistor.

The first and second transistors can be coupled to form a Doherty amplifier circuit. The first and the second transistors may form a symmetric or an asymmetric Doherty amplifier circuit. In embodiments the circuit may further comprise a power distribution network for distributing the power of the electrical signal between the first and the second amplifier branches according to a predefined ratio. The predefined ratio can be such that the second transistor provides at least 2/3 of a total output power of both transistors when both transistors provide their maximum output power. In further embodiments the circuit may further comprise an impedance transforming network for changing the phase of the electrical signal such that at an input signal of the first amplifier branch substantially has a phase, which is 90 degrees ahead of an input signal of the second amplifier branch.

The circuit can further comprise an impedance transforming network at the output of the first amplifier branch. The second amplifier branch can be adapted for amplifying the electrical signal when a level of the electrical signal is above the predefined threshold, and for not amplifying the electrical signal when the level of the electrical signal is below the predefined threshold, and the impedance transforming network can be adapted to provide a higher output impedance to the first amplifier branch, when the level of the electrical signal is below the predefined threshold as compared to when the level of the electrical signal is above the predefined threshold.

Embodiments may also provide a radio transmitter comprising on of the above amplification circuits. Embodiments may further provide a method for amplifying an electrical signal. The method may comprise a step of amplifying the electrical signal with a first amplifier branch comprising a first transistor, and a step of amplifying the electrical signal with a second amplifier branch comprising a second transistor, when the level of the electrical signal is above a predefined threshold. The first and the second transistors are based on different transistor technologies.

### Brief description of the Figures

Some other features or aspects will be described using the following non-limiting embodiments of apparatuses and/or methods and/or computer programs by way of example only, and with reference to the accompanying figures, in which
Figure 1 shows a block diagram of an embodiment;
Figure 2 shows a principal circuit diagram of an embodiment;
Figure 3 shows a view chart illustrating efficiency increases with an embodiment; and
Figure 4 shows a flow chart of an embodiment of a method.

### Description of some Embodiments

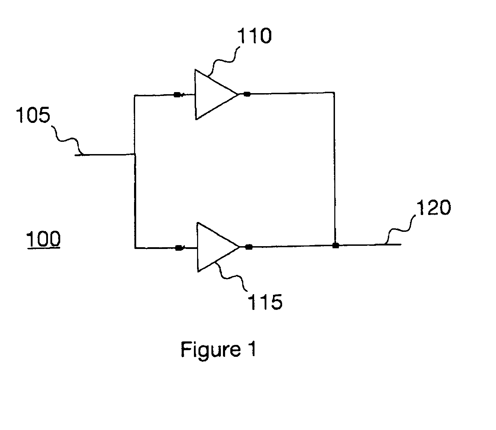

The illustrative description of the embodiments will be given in details combined with the appended figures. Figure 1 shows a block diagram of an embodiment of a circuit 100 adapted for amplifying an electrical signal, which is input at input connector 105. The circuit 100 comprises a first amplifier branch 110 comprising a first transistor adapted for amplifying the electrical signal and a second amplifier branch 115 comprising a second transistor adapted for amplifying the electrical signal, when the level of the electrical signal is above a predefined threshold. The first and the second transistors are based on different transistor technologies. The amplified signal is output at connector 120.

In the embodiment shown in Figure 1 the first and the second amplifier branches 105,110 are coupled in parallel. In embodiments it can be assumed that the electrical signal has a carrier part, having a carrier amplitude, and a modulation part, having a peak amplitude. The predefined threshold may separate the carrier amplitude from the peak amplitude. The first amplifier branch 110 can be adapted for amplifying the carrier part and the modulation part of the electrical signal, and the second amplifier branch 115 can be adapted for amplifying the peak amplitude. In other words, the first amplifier branch 110 can be adapted for always amplifying the electrical signal, while the second amplifier branch 115 amplifies only higher amplitudes of the electrical signal, while it is adapted for not amplifying lower amplitudes of the electrical signal. In embodiments the predefined threshold may determine or separate lower and higher amplitudes. The crossover between lower and higher amplitudes of the electrical signal may correspond to a hard switching operation, switching the second amplifier branch 115 on and off. In other embodiments the crossover may rather correspond to a soft switching operation, where for the lower amplitudes of the electrical signal the first amplifier branch 110 contributes the significant part of the output signal's power, while the second amplifier branch 115 contributes only a negligible part of the output signal's power, and for the higher amplitudes of the electrical signal the second amplifier branch 115 contributes a significant part of the output signal's power.

In embodiments the second amplifier branch 115 can be adapted for amplifying the electrical signal when a level of the electrical signal is above the predefined threshold, and for not amplifying the electrical signal when the level of the electrical signal is below the predefined threshold.

The first and the second transistors can be, for example, from the group of GaN, GaAs, GaC₂, Ge, Si, SiGe, LDMOS, MOSFET, IGBT, BJT, JFET, IGFET. For example, the first transistor corresponds to a GaN-transistor and the second transistor corresponds to a LDMOS-transistor.

In some embodiments the first and second transistors can be coupled to form a Doherty amplifier circuit. The first and the second transistors form a symmetric or an asymmetric Doherty amplifier circuit, i.e. for the maximum output power of the Doherty structure both amplifier branches 110, 115 may contribute equal or symmetric shares to the output power. In other embodiments the load sharing between the first and the second amplifier branches 110, 115 may be asymmetric, i.e. for the maximum output power of the Doherty structure one of the amplifier branches 110, 115 may contribute a higher share to the overall output power than the other. For example, the second amplifier branch 115 may contribute twice as much power to the output signal than the first amplifier branch 110 at maximum overall output power.

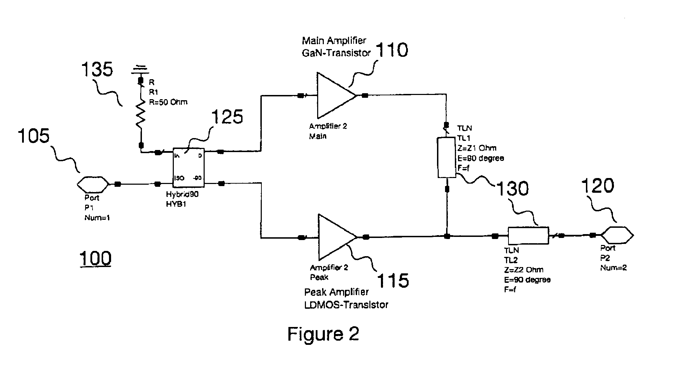

Figure 2 shows a principal circuit diagram of an embodiment. In Figure 2, similar components are shown as in Figure 1, they are referenced by the same reference signs. Thus, Figure 2 shows an embodiment of the circuit 100, the input connector 105, the first amplifier branch 110, the second amplifier branch 115, and the output connector 120. The in- and output connectors 105, 120 can also be referred to as ports. As shown in Figure 2, in embodiments the circuit 100 may further comprise a power distribution network 125 for distributing the power of the electrical signal between the first and the second amplifier branches 110, 115 according to a predefmed ratio. As has already been described above, the predefined ratio may depend on the operating point of the circuit. For example, the predefined ratio can be such that the second transistor provides at least 2/3 of a total output power of both transistors when both transistors provide their maximum output power.

Furthermore, in the embodiment depicted in Figure 2 the circuit 100 further comprises an impedance transforming network 125 for changing the phase of the electrical signal such that at an input signal of the first amplifier branch 110 substantially has a phase, which is 90 degrees ahead of an input signal of the second amplifier branch 115. In the embodiment illustrated in Figure 2, the power distribution network and the impedance transforming network are shown as one entity 125. In other embodiments they can be implemented as separate entities.

Moreover, the circuit 100 may comprise an impedance transforming network 130 at the output of the first amplifier branch 110. The first and the second impedance transforming networks 125 and 130 may be adapted to a Doherty amplifier structure, i.e. the impedance transforming network 125 at the input may change the phase of the input signals to the first and second amplifier branches 110, 115, such that, together with another phase change of the output signals by the impedance transforming network 130, the phase of the output signal of the second amplifier branch 115 is such that an impedance at the output of the first amplifier branch 110 is decreased with increasing output power of the second amplifier branch 115.

As already described for the above embodiment, the second amplifier branch can be adapted for amplifying the electrical signal when a level of the electrical signal is above the predefined threshold, and for not amplifying the electrical signal when the level of the electrical signal is below the predefined threshold. The impedance transforming network 130 can be adapted to provide a higher output impedance to the first amplifier branch 110, when the level of the electrical signal is below the predefined threshold as compared to when the level of the electrical signal is above the predefined threshold. Furthermore, embodiments may further comprise a referencing network 135 to a reference potential.

Figure 2 can also be interpreted as a principal schematic of an asymmetric Doherty amplifier. The power distribution network 125, the impedance transforming network 125, respectively, may correspond to an input splitter for splitting the input signal, i.e. the electrical signal, between a main amplifier, corresponding to the first amplifier branch 110, and a peak amplifier, corresponding to the second amplifier branch 115. Furthermore, in Figure 2 there are impedance transforming transmission lines at the output corresponding to the impedance transformation network 130, to provide an appropriate load impedance modulation for the main amplifier, i.e. the first amplifier branch 110.

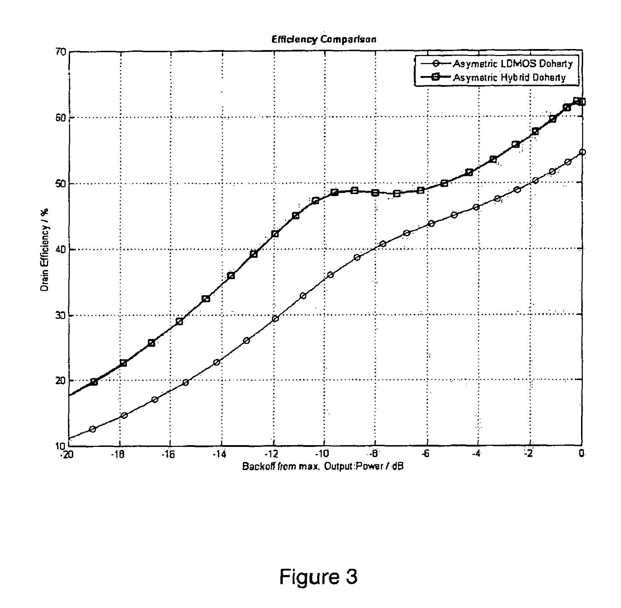

Figure 3 shows a view chart illustrating efficiency increases with an embodiment. In Figure 3 the back off from the maximum output power of a Doherty amplifier, along the lines of Figure 2, is shown on the abscissa. The back off is given in dB. The drain efficiency is shown on the ordinate and given in percent. Figure 3 shows a comparison of two asymmetric Doherty structures. The first is implemented using LDMOS transistors in both amplifier branches and its results are indicated by circular markers. The second structure uses a hybrid Doherty structure according to an embodiment using two different transistor-technologies for the main and the peak device, i.e. for the first and the second amplifier branches. The amplifier concept of the second structure also corresponds to an asymmetric Doherty with a power split ratio of 1:2 between the main, first amplifier branch, and peak amplifier, second amplifier branch. The embodiment seeks to improve efficiency at an output back off of -7.8dB. This efficiency maximum is mainly determined by the efficiency of the main transistor, i.e. the first transistor in the first amplifier branch. Therefore this embodiment uses a highly efficient GaN-transistor as main device for the first amplifier branch and a relatively cheap LDMOS-transistor as peak device for the second amplifier branch. The word "Hybrid" in this case refers to the two different transistor technologies used. The results for the second structure are indicated by square-shaped markers.

As can easily be seen from Figure 3, the efficiency of the Hybrid Doherty in the embodiment is significantly higher than that of a LDMOS-only amplifier. Efficiency improvements in the range of 10% can be expected over a large dynamic range.

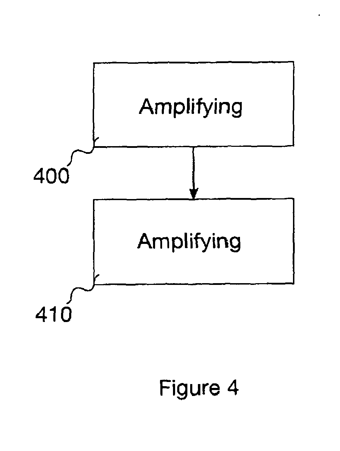

Embodiments may also provide a radio transmitter comprising an embodiment of the above circuit 100. Moreover, embodiments may provide a method for amplifying an electrical signal, as illustrated by the flow chart in Figure 4. The method may comprise a step 400 of amplifying the electrical signal with a first amplifier branch 110 comprising a first transistor and a step 410 of amplifying the electrical signal with a second amplifier branch 115 comprising a second transistor, when the level of the electrical signal is above a predefined threshold. The first and the second transistors are based on different transistor technologies.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

The functions of the various elements shown in the figures, including any functional blocks labeled as "power distribution network", may be provided through the use of dedicated hardware, as e.g. an application specific integrated circuit ASIC processor, a controller, as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. A circuit (100) adapted for amplifying an electrical signal, comprising
a first amplifier branch (110) comprising a first transistor adapted for amplifying the electrical signal; and
a second amplifier branch (115) comprising a second transistor adapted for amplifying the electrical signal, when the level of the electrical signal is above a predefined threshold,
wherein the first and the second transistors are based on different transistor technologies.

2. The circuit (100) of claim 1, wherein the first and the second amplifier branches (110; 115) are coupled in parallel.

3. The circuit (100) of claim 1, wherein the electrical signal has a carrier part having a carrier amplitude and a modulation part having a peak amplitude, wherein the predefined threshold separates the carrier amplitude from the peak amplitude.

4. The circuit (100) of claim 3, wherein the first amplifier branch (110) is adapted for amplifying the carrier part and the modulation part of the electrical signal, and wherein the second amplifier branch (115) is adapted for amplifying the peak amplitude.

5. The circuit (100) of claim 1, wherein the second amplifier branch (115) is adapted for amplifying the electrical signal when a level of the electrical signal is above the predefined threshold, and for not amplifying the electrical signal when the level of the electrical signal is below the predefined threshold.

6. The circuit (100) of claim 1, wherein the first and the second transistors are from the group of GaN, GaAs, GaC₂, Ge, Si, SiGe, LDMOS, MOSFET, IGBT, BJT, JFET, IGFET.

7. The circuit (100) of claim 1, wherein the first and second transistors are coupled to form a Doherty amplifier circuit.

8. The circuit (100) of claim 7, wherein the first and the second transistors form a symmetric or an asymmetric Doherty amplifier circuit.

9. The circuit (100) of claim 1, further comprising a power distribution network adapted for distributing the power of the electrical signal between the first and the second amplifier branches (110;115) according to a predefined ratio.

10. The circuit (100) of claim 9, wherein the predefined ratio is such that the second transistor provides at least 2/3 of a total output power of both transistors when both transistors provide their maximum output power.

11. The circuit (100) of claim 9, further comprising an impedance transforming network (125) adapted for changing the phase of the electrical signal such that at an input signal of the first amplifier branch (110) substantially has a phase, which is 90 degrees ahead of an input signal of the second amplifier branch (115).

12. The circuit (100) of claim 1, wherein the circuit further comprises an impedance transforming network at the output of the first amplifier branch (110).

13. The circuit (100) of claim 12, wherein the second amplifier branch (115) is adapted for amplifying the electrical signal when a level of the electrical signal is above the predefined threshold, and for not amplifying the electrical signal when the level of the electrical signal is below the predefined threshold, and wherein the impedance transforming network (130) is adapted to provide a higher output impedance to the first amplifier branch (110), when the level of the electrical signal is below the predefined threshold as compared to when the level of the electrical signal is above the predefined threshold.

14. A radio transmitter comprising the circuit (100) of claim 1.

15. A method for amplifying an electrical signal, comprising
amplifying (400) the electrical signal with a first amplifier branch (110) comprising a first transistor; and
amplifying (410) the electrical signal with a second amplifier branch (115) comprising a second transistor, when the level of the electrical signal is above a predefined threshold,
wherein the first and the second transistors are based on different transistor technologies.
